# EUROPÄISCHE PATENTSCHRIFT

(11) **EP 2 963 541 B1**
(45) Veröffentlichungstag und Bekanntmachung des Hinweises auf die Patenterteilung: **25.01.2017**
(21) Anmeldenummer: 14174904.4
(22) Anmeldetag: 30.06.2014
(51) Int. Cl.: G06F 9/44, G06F 17/50, G06F 11/36

(54) **Implementierung einer Konstanten in FPGA-Code**
Implementation of a constant in FPGA code
Implémentation d'une constante dans un code FPGA

(43) Veröffentlichungstag der Anmeldung: 06.01.2016
(73) Patentinhaber: dSPACE digital signal processing and control engineering GmbH, 33102 Paderborn (DE)
(72) Erfinder: Kalte, Heiko, 33106 Paderborn (DE); Funke, Lukas, 33102 Paderborn (DE)

(56) Entgegenhaltungen:
- WO-A2-2009/009082
- US-A1- 2004 148 151

## Beschreibung

Die vorliegende Erfindung betrifft ein Verfahren zum Erstellen eines FPGA-Codes basierend auf einem FPGA-Modell mit wenigstens einem Signalwert, der als Konstante modelliert wird. Des Weiteren betrifft die Erfindung ein Verfahren zum Kalibrieren eines FPGA-Modells. Auch betrifft die Erfindung ein Computerprogrammprodukt mit Computer-implementierten Anweisungen, das nach dem Laden und Ausführen in einer geeigneten Datenverarbeitungseinrichtung die Schritte des obigen Verfahrens ausführt. Ferner betrifft die Erfindung ein digitales Speichermedium mit elektronisch auslesbaren Steuersignalen, die so mit einer programmierbaren Datenverarbeitungseinrichtung zusammenwirken können, dass das obige Verfahren auf der Datenverarbeitungseinrichtung ausgeführt wird.

Aus der WO 2009/009082 A2 sind Parameter bekannt für die ein Speicher und eine Schnittstelle im HDL-Code generiert werden, wenn die Parameter als veränderbar deklariert werden.

Aus der US 2004/0148151 A1 sind Parameter bekannt, die entweder im RAM oder im ROM abgelegt werden.

Echtzeitsimulationen von komplexen, dynamischen Modellen stellen aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen, z.B. für sehr dynamische Teile des Umgebungsmodells. Dies ist etwa bei der Simulation von Zylinderinnendrucksensoren der Fall, die bei der Verbrauchs- oder Abgasreduktion eine zunehmend größere Rolle spielen. Aber auch bei Regelstrecken, die eine hohe Dynamik aufweisen, wie zum Beispiel bei Elektromotoren, sind kurze Zykluszeiten und geringe Latenzen unabdingbar. Diese können mit CPU-basierten Simulationen praktisch kaum mehr umgesetzt werden. Ein weiteres Beispiel stellt der Bereich Rapid Control Prototyping (RCP) dar. In solchen Fällen halten Field Programmable Gate Arrays (FPGA) immer mehr Einzug, so dass ausreichend präzise und schnelle Reaktionszeiten der Modelle gewährleistet bleiben. So können die simulierten Umgebungsmodelle (z.B. simulierter Elektromotor) oder die Steuergeräte zuverlässig implementiert werden, indem beispielsweise komplexe Reglerteile in das FPGA ausgelagert werden. Somit können die simulierten Umgebungsmodelle immer genauer und komplexer werden.

FPGAs können Rechenknoten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Eine solche Erweiterung für einen HiL-Simulator stellt beispielsweise das DS5203-FPGA Board von dSPACE dar. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA Hardware-Konfiguration wird üblicherweise basierend auf einem FPGA-Modell in einer Hardwarebeschreibungssprache in einem Build-Prozess erzeugt.

Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset Matlab/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

In einer CPU-basierenden Echtzeitsimulation wird das Blockschaltbild eines Modells mit Hilfe des Simulink Coders zunächst in C/C++ Quelldateien übersetzt. Diese werden anschließend über einen Compiler in eine ausführbare Applikation übersetzt, die auf einem Rechenknoten mit einem echtzeitfähigen Betriebssystem ausgeführt werden kann. Zusätzlich wird bei dem CPU-Build ein Trace-File erzeugt, welches ein Topologie File mit seiner grafischen Modellierung, beispielsweise in Simulink, darstellt.

Die Übersetzung eines Modells in eine CPU-Applikation hat zur Folge, dass die Berechnungen der Simulation sequenziell, in einer festen Schrittweite ausgeführt werden. Ein konsistentes Abbild aller Modellzustände oder Modell-Variablen, wie beispielsweise Daten auf den Signalleitungen oder Ein/Ausgabewerte der Blöcke, ist damit stets im Hauptspeicher des Rechenknotens vorhanden. Durch den direkten Zugang zum Hauptspeicher können zur Laufzeit des Modells die Modell-Variablen in einem Experimentiertool wie bspw. ControlDesk analysiert und/oder manipuliert werden. Ein wahlfreier Schreib-/Lese-Zugriff auf Variablen der HiL-Simulation ist möglich. Anhand des Trace Files können Signalwerte wie z.B. Motor-Drehzahl ausgewählt und durch eine Anzeige ausgeben oder manipuliert werden. Im HiL-Umfeld fasst man diese Vorgehensweise unter den Begriffen "Messen" und "Verstellen" zusammen.

Eine FPGA-basierte Simulation kann unter Zuhilfenahme des Xilinx System Generator (XSG) und des FPGA-Programming Blocksets von dSPACE, analog zur CPU-basierten Simulation, in einem Blockschaltbild mit Simulink modelliert werden.

Im Gegensatz zur CPU-Simulation wird dieses Modell allerdings nicht in eine iterative Programmiersprache übersetzt, sondern in eine Hardwarebeschreibungssprache, die eine kundenspezifische digitale Schaltung beschreibt. Die Beschreibung der kundenspezifischen Schaltung wird durch einen Syntheseprozess in einen FPGA-Konfigurationsdatenstrom übersetzt. Somit fehlt eine Möglichkeit, um Signale, welche auf dem FPGA platziert wurden, zu verstellen. Insbesondere im Bereich der Kalibrierung von Steuergeräten, bei der sehr viele Parameter eingestellt werden müssen, ist daher ein ressourcen- und zeitsparendes Verfahren wünschenswert.

Kalibrierdaten sind üblicherweise als Konstanten modelliert und implementiert, so dass eine Veränderung zur Laufzeit des FPGA üblicherweise nicht erfolgen kann. Dies ist für ein finales Modell, beispielsweise eine Release-Version oder Normalversion, durchaus wünschenswert, da die Implementierung von Konstanten in FPGAs auf einfache Weise und mit wenig Ressourcen realisiert werden kann. Allerdings wird durch die Konstanten das Kalibrieren und Debuggen erschwert, da für die Veränderung der Signalwerte der Konstanten jeweils ein neuer FPGA-Code erzeugt werden muss. Ein abweichende Modellierung der Konstanten als Variablen könnte dieses Problem in Bezug auf das verändern der Signalwerte lösen. Aufgrund der Implementierung der Variablen mit veränderlichen Werten als FPGA-Code ergeben sich hieraus jedoch Nachteile in Bezug auf die Performance des FPGA-Modells wie auch die Nutzung von Ressourcen. Unterschiedliche Implementierungen, beispielsweise ein FPGA-Modell mit Variablen mit veränderlichen Werten für das Kalibrieren und Debuggen, und ein FPGA-Modell mit Konstanten mit statischen Signalwerten für das Release bergen den Nachteil, dass das FPGA-Modell für den Übergang zu dem Release verändert werden muss, was Fehleranfällig ist. Auch können sich Unterschiede in Bezug auf die Performance durch die unterschiedliche Modellierung ergeben, wodurch mögliche Fehler mitunter nicht erkannt werden oder erst in dem Release des FPGA-Codes auftreten.

Ausgehend von dem oben genannten Stand der Technik liegt der Erfindung somit die Aufgabe zugrunde, ein Verfahren, eine Datenverarbeitungseinrichtung, ein Computerprogrammprodukt sowie ein digitales Speichermedium mit elektronisch auslesbaren Steuersignalen der oben genannten Art anzugeben, welche ein Erstellen eines FPGA-Codes in einer einfachen und effizienten Weise ermöglichen, die eine hohe Fehlersicherheit beim Erstellen des FPGA-Codes erreichen und die eine einfache und effiziente Verwendung des FPGA-Codes zur Entwicklung, insbesondere Kalibrierung ermöglichen. Außerdem liegt der Erfindung die Aufgabe zugrunde, ein Verfahren, eine Datenverarbeitungseinrichtung, ein Computerprogrammprodukt sowie ein digitales Speichermedium mit elektronisch auslesbaren Steuersignalen der oben genannten Art anzugeben, welche eine einfache und effiziente Entwicklung, insbesondere Kalibrierung von FPGA-Codes ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zum Erstellen eines FPGA-Codes basierend auf einem FPGA-Modell mit wenigstens einem Signalwert, der als Konstante modelliert wird, vorgesehen, umfassend die Schritte Einfügen einer Konstanten mit einem vorgegebenen Signalwert in dem FPGA-Modell, Setzen einer Schaltvariablen in dem FPGA-Modell zum Umschalten zwischen einem Normalmodus und einem Kalibriermodus für den FPGA-Code, Erzeugen des FPGA-Codes für das FPGA-Modell umfassend das Implementieren der Konstanten in dem FPGA-Code, wobei das Implementieren der Konstanten bei gesetzter Schaltvariable für den Normalmodus das Implementieren der Konstanten als fester Wert in dem FPGA-Code umfasst, und das Implementieren der Konstanten bei gesetzter Schaltvariable für den Kalibriermodus das Implementieren der Konstanten als veränderbarer Signalwert in dem FPGA-Code umfasst.

Erfindungsgemäß ist ferner eine Datenverarbeitungseinrichtung mit einer Prozessoreinheit angegeben, wobei die Datenverarbeitungseinrichtung zur Durchführung des obigen Verfahrens ausgeführt ist.

Erfindungsgemäß ist auch ein Computerprogrammprodukt mit Computer-implementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Grundidee der vorliegenden Erfindung ist es also, durch die Schaltvariable in dem FPGA-Modell ein einfaches Umschalten zwischen dem Normalmodus und dem Kalibriermodus zu ermöglichen, so dass der erzeugte FPGA-Code auf einfache und effiziente Weise für den jeweiligen Modus angepasst werden kann. Somit kann ein einzelnes FPGA-Modell ohne strukturelle Veränderungen sowohl für die Kalibrierung wie auch für den späteren Einsatz im Normalbetrieb verwendet werden. Für die Konstanten erfolgt in dem FPGA-Code also eine unterschiedliche Implementierung abhängig von der gesetzten Schaltvariablen.

Ausgehend von einem FPGA-Modell kann für den Normalmodus der FPGA-Code für eine effiziente Implementierung erzeugt werden, während für den Kalibriermodus der FPGA-Code eine große Flexibilität für die Kalibrierung oder Ähnliches aufweist, beispielsweise für ein effiziente Bestimmung von Kalibrierwerten für den finalen FPGA-Code.

Die Implementierung als fester Wert entspricht dabei der Standardimplementierung der Codeerzeugungswerkzeuge für Konstanten. Den Codeerzeugungswerkzeugen werden hier also keine Vorgaben für die Implementierung vorgegeben.

Die Implementierung der Konstanten als veränderbarer Signalwert kann prinzipiell auf unterschiedliche Weise erfolgen. Details dazu sind nachstehen angegeben. Dabei können die Signalwerte entweder unmittelbar verändert werden, wenn die Signalwerte quasi im "Klartext" in dem FPGA implementiert sind. Alternativ kann die Implementierung erfordern, dass eine Übersetzung von Informationen aus dem FPGA-Code in den Signalwert erfolgt. Dies ist abhängig von der Art der Implementierung der Konstanten als veränderbarer Signalwert in dem FPGA-Code. Eine Übersetzungsvorschrift kann im Zuge der Erzeugung des FPGA-Codes ermittelt werden, sodass auch zur Laufzeit des FPGA zuverlässig Änderungen an dem veränderbaren Signalwert erfolgen können.

In einer bevorzugten Ausgestaltung ist der veränderbare Signalwert zusätzlich auslesbar. Diese Implementierung des FPGA-Codes ermöglicht es, den jeweils aktuellen Signalwert auszulesen, um diesen beispielsweise bei einer erfolgreichen Kalibrierung zu speichern und später zu verwenden, beispielsweise für die Definition des Signalwerts der Konstanten im Normalmodus. Auslesbar kann der Signalwert bspw. sein, wenn sein Wert direkt oder indirekt an einen I/O-Port ausgegeben wird oder wenn die Konfigurationsbits, die den Wert im FPGA festlegen über einen Readback-Mechanismus ausgelesen werden können. Der Readback-Mechanismus kann bspw. genutzt werden, wenn der Wert der Konstanten in einem Register implementiert ist.

Weiter bevorzugt ist, dass die Schaltvariable eine Voreinstellung für den Kalibriermodus aufweist. Damit wird davon ausgegangen, dass zunächst eine Erstellung des FPGA-Codes für den Kalibriermodus erfolgt, so dass die Schaltvariable nur für den Normalmodus entsprechend gesetzt werden muss, d.h. es ist nur eine aktive Änderung der Schaltvariablen durch eine Nutzer erforderlich, wenn der FPGA-Code für den Normalmodus erzeugt werden soll.

In vorteilhafter Ausgestaltung der Erfindung umfasst der Schritt des Einfügen einer Schaltvariablen in dem FPGA-Modell zum Umschalten zwischen einem Normalmodus und einem Kalibriermodus das Zuordnen der Schaltvariablen zu wenigstens einer Konstanten. Dies ist von Vorteil, wenn unterschiedliche Teile des FPGA-Modells kalibriert werden sollen, und diese Kalibrierung unabhängig erfolgen kann. Da nur ein Teil der Konstanten als veränderbarer Signalwert in dem FPGA-Code bereitgestellt wird, kann der FPGA-Code unter Verwendung weniger FPGA-Ressourcen, beispielsweise I/O-Ports, bereitgestellt werden. Vorzugsweise kann eine Mehrzahl Konstanten über eine Schaltvariable konfiguriert werden, d.h. das Implementieren einer Mehrzahl Konstanten wird durch eine Schaltvariable bestimmt. Weiter bevorzugt erfolgt eine Zuordnung von Konstanten zu einer Schaltvariable basierend auf einer definierten Gruppe von Konstanten. Die Zuordnung von Schaltvariable und Konstanten kann ausgehend von der Konstanten oder der Schaltvariablen in dem FPGA-Modell erfolgen. Beispielsweise kann die Schaltvariable für alle Konstanten in einen Subsystem des FPGA-Modells gelten. Alternativ ist die Schaltvariable als globale Schaltvariable ausgeführt, so dass durch das Setzen einer Schaltvariable das Implementieren aller Konstanten gesteuert werden kann.

In vorteilhafter Ausgestaltung der Erfindung umfasst der Schritt des Implementierens der Konstanten als veränderbarer Signalwert das Implementieren der Konstanten mit Registern. Durch die Verwendung von Registern kann auf den veränderbaren Signalwert auf einfache Weise zugegriffen werden, um den Signalwert zu verändern. Entsprechendes gilt für ein mögliches Auslesen des veränderbaren Signalwertes. Durch die Implementierung der Konstanten mit Registern kann quasi im "Klartext" auf den veränderlichen Signalwert zugegriffen werden, so dass eine komplexe Umwandlung eines Signalwertes auf den FPGA-Code entfallen kann.

In vorteilhafter Ausgestaltung der Erfindung umfasst der Schritt des Implementierens der Konstanten als veränderbarer Signalwert in dem FPGA-Code das Implementieren von FPGA-Komponenten und/oder Signalpfaden zum Setzen des veränderbaren Signalwerts. Damit kann der veränderbare Signalwert zuverlässig gesetzt werden. Die FPGA-Komponenten können unterschiedlich ausgestaltet sein, wie nachstehend angegeben. Es können prinzipiell auch bestehende Komponenten verwendet werden, indem deren Signalwerte, beispielsweise entlang von Signalpfaden, als veränderbare Signalwerte verwendet werden. Üblicherweise werden die veränderbaren Signalwerte jedoch von außen auf ein FPGA-Board zur Ausführung des FPGA-Codes übertragen.

In vorteilhafter Ausgestaltung der Erfindung umfasst der Schritt des Implementierens von FPGA-Komponenten und/oder Signalpfaden zum Setzen des veränderbaren Signalwerts das Implementieren und Verbinden eines I/O-Ports zum Setzen des veränderbaren Signalwerts in dem FPGA-Code. Somit können die veränderbaren Signalwerte von außen auf ein FPGA-Board zur Ausführung des FPGA-Codes übertragen werden, indem die veränderbaren Signalwerte über die I/O-Ports bereitgestellt werden. Auch ein Auslesen der veränderbaren Signalwerte kann über die I/O-Ports auf einfach Weise erfolgen. Bei der Verwendung von Registern für die Implementierung der Konstanten als veränderbarer Signalwert können die I/O-Ports beispielsweise unmittelbar mit den Registern verbunden werden, um die Registerinhalte zu verändern. Dazu kann nach dem Anlegen eines Signalwertes über die I/O-Ports beispielsweise ein Enable-Signal an die Register angelegt werden, um den Signalwert von den I/O-Ports in die Register als veränderbarer Signalwert zu übernehmen.

In vorteilhafter Ausgestaltung der Erfindung umfasst der Schritt des Implementierens von FPGA-Komponenten und/oder Signalpfaden zum Setzen des veränderbaren Signalwerts das Implementieren eines Schieberegisters zum Setzen des veränderbaren Signalwerts in dem FPGA-Code. Das Schieberegister ermöglicht es, über einen oder wenige I/O-Ports praktisch beliebige Signalwerte bereitzustellen, indem einzelne Bits des Signalwerts sequenziell übertragen werden. Aufgrund der hohen Geschwindigkeit von Implementierungen als FPGA-Code sind Verzögerungen, die aufgrund der sequenziellen Übertragung auftreten können üblicherweise zu vernachlässigen. Vorteile ergeben sich dadurch, dass Schieberegister einen geringen Ressourcenoverhead erfordern und eine einfache Skalierung für verschiedene veränderbare Signalwerte erfolgen kann. Auch eine Skalierung für eine große Anzahl von Konstanten kann einfach erfolgen.

In vorteilhafter Ausgestaltung der Erfindung umfasst der Schritt des Implementierens von FPGA-Komponenten und/oder Signalpfaden zum Setzen des veränderbaren Signalwerts das Implementieren eines Multiplexes zum Setzen des veränderbaren Signalwerts in dem FPGA-Code. Über Multiplexer können von einen oder mehrere I/O-Ports Signalwerte parallel bereitgestellt und als veränderbarer Signalwert übernommen werden. Somit kann der Signalwert direkt übernommen werden und Verzögerungen können auf ein Minimum reduziert werden.

In vorteilhafter Ausgestaltung der Erfindung unterscheidet das FPGA-Modell für Konstanten zwischen mindestens einem Festwertblock und mindestens einem Kalibrierblock, wobei der Wert des mindestens einen Konstantblocks unabhängig von der Schaltvariablen als fester Wert im FPGA-Code implementiert wird und der Wert des mindestens einen Kalibrierblocks in Abhängigkeit der Schaltvariablen im Normalmodus als fester Wert und im Kalibriermodus als veränderbarer Signalwert implementiert wird

Erfindungsgemäß ist zusätzlich ein Verfahren zum Kalibrieren eines FPGA-Modells angegeben, umfassend die Schritte Erstellen eines FPGA-Codes basierend auf einem FPGA-Modell mit wenigstens einem Signalwert, der als Konstante modelliert wird, wobei die Schaltvariable für den Kalibriermodus gesetzt ist, Kalibrieren des FPGA-Codes umfassend das Setzen einer Mehrzahl Signalwerte für den veränderlichen Signalwert, Bestimmen eines Signalwert als Kalibrierwert für die Konstante, Implementieren des Kalibrierwertes für die Konstante in dem FPGA-Modell, Erstellen eines FPGA-Codes basierend auf dem FPGA-Modell mit dem Kalibrierwert für die Konstante, wobei die Schaltvariable für den Normalmodus gesetzt ist.

Erfindungsgemäß ist ferner eine Datenverarbeitungseinrichtung mit einer Prozessoreinheit und einem FPGA angegeben, wobei die Datenverarbeitungseinrichtung zur Durchführung des obigen Verfahrens ausgeführt ist.

Erfindungsgemäß ist auch ein Computerprogrammprodukt mit Computer-implementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Grundidee ist es auch hier, durch die Verwendung eines FPGA-Modells zusammen mit der Schaltvariablen eine effiziente Kalibrierung oder Ähnliches durchführen zu können, ohne dass das FPGA-Modell verändert werden muss. Nach erfolgreicher Kalibrierung kann ausgehend von dem FPGA-Modell durch Setzen der Schaltvariablen für den Normalmodus ein finaler FPGA-Code erzeugt werden. Dabei wird der Kalibrierwert für die Konstante einbezogen. Somit entfallen Fehlerquellen, wie sie sich prinzipiell bei der Änderung eines FPGA-Modells ergeben.

Das Ändern der veränderbaren Signalwerte kann abhängig von der Implementierung im FPGA-Code entweder unmittelbar erfolgen, wenn die veränderbaren Signalwerte quasi im "klartext" in dem FPGA implementiert sind. Dies ist abhängig von der Art der Implementierung der Konstanten als veränderbarer Signalwert in dem FPGA-Code.

Andernfalls ist eine Übersetzungsvorschrift erforderlich, um einen Signalwert für den veränderbaren Signalwert zu setzen. Die Übersetzungsvorschrift wird vorzugsweise bei der Erzeugung des FPGA-Codes ermittelt, sodass sie zur Ausführung des FPGA-Codes verfügbar ist und ein ändern des veränderbaren Signalwertes ermöglicht. Eine Übersetzungsvorschrift kann beispielsweise eine Beziehung zwischen dem Signalwert und der Konfiguration von einem oder mehreren Logikelementen des FPGAs wie zum Beispiel Multiplexer oder Look-Up-Tables sein.

Durch die Implementierung des FPGA-Codes mit Signalwerten als Konstanten im Kalibriermodus ist es somit möglich, zur Laufzeit des FPGA zuverlässig Änderungen an dem veränderbaren Signalwert durchzuführen. Ein sonst erforderliches erneutes Erzeugen des FPGA-Codes, was sehr zeitaufwendig ist, kann entfallen. Auch ein Ändern des FPGA-Modells ist nicht erforderlich, um die Kalibrierung durchzuführen.

In vorteilhafter Ausgestaltung der Erfindung umfasst das Verfahren den zusätzlichen Schritt des Speicherns eines Signalwertes aus dem FPGA-Code in das FPGA-Modell. Damit kann der Signalwert unmittelbar aus dem FPGA-Code in das FPGA-Modell übernommen werden, so dass ein fertig kalibrierter FPGA-Code auf einfache Weise mit geringem Aufwand erzeugt werden kann. Beispielsweise kann ein Nutzer einen Signalwert für das Speichern auswählen, oder es erfolgt eine automatische Auswahl des Signalwertes unter Berücksichtigung von mehreren verwendeten Signalwerten. Die Auswahl kann von einem Host-Rechner oder einem Rechenknoten, mit dem ein FPGA-Board zur Ausführung des FPGA-Codes verbunden ist, durchgeführt werden. Dazu kann auf diesem Host-Rechner oder Rechenknoten eine übergeordnete Software zum Bestimmen eines Signalwert als Kalibrierwert für die Konstante ausgeführt werden. Auch kann ein automatisches Speichern von Änderungen an den veränderbaren Signalwerten erfolgen.

In vorteilhafter Ausgestaltung der Erfindung umfasst der Schritt des Bestimmens eines Signalwert als Kalibrierwert für die Konstante das automatische Übernehmen eines aktuellen Signalwerts aus dem FPGA-Code in das FPGA-Modell. So können beispielsweise Kalibrierwerte übernommen werden, wie sie am Ende der Kalibrierung in dem FPGA-Code als Signalwerte für die veränderbaren Signalwerte enthalten sind. Somit können beispielsweise beim Beenden der Kalibrierung die vorliegenden Signalwerte als Kalibrierwerte übernommen werden.

In vorteilhafter Ausgestaltung der Erfindung umfasst das Verfahren den zusätzlichen Schritt des Verbindens eines FPGA-Boards zur Ausführung des erstellten FPGA-Codes mit einem Steuergerät, insbesondere einem Echtzeitsteuergerät. Somit kann die Kalibrierung im Zusammenspiel mit dem Steuergerät erfolgen.

Nachfolgend wird die Erfindung unter Bezugnahme auf die anliegende Zeichnung anhand bevorzugter Ausführungsformen näher erläutert.

Es zeigen
- Fig. 1: eine schematische Darstellung eines Datenverarbeitungssystems mit einem Steuerungsrechner und einem Echtzeitsystem,
- Fig. 2: ein Ablaufdiagramm eines Verfahrens zum Erstellen eines FPGA-Codes gemäß einer bevorzugten Ausführungsform,
- Fig. 3: eine schematische Darstellung eines Build Verfahrens zur Erzeugung von Modellen für verschiedene Komponenten des Datenverarbeitungssystems aus Fig. 1,
- Fig. 4: eine vereinfachte, schematische Darstellung eines FPGA-Modells mit Konstanten,
- Fig. 5: eine schematische Darstellung einer Implementierung eines veränderbaren Signalwerts in einem FPGA-Code mit Registern,
- Fig. 6: eine schematische Darstellung einer Implementierung eines über partielle Rekonfiguration veränderbaren Signalwerts in einem FPGA-Code mit Registern,
- Fig. 7: ein Ablaufdiagramm eines Verfahrens zum Kalibrieren eines FPGA-Modells gemäß einer bevorzugten Ausführungsform,und
- Fig. 8: eine schematische Darstellung einer Implementierung eines festen Wertes.

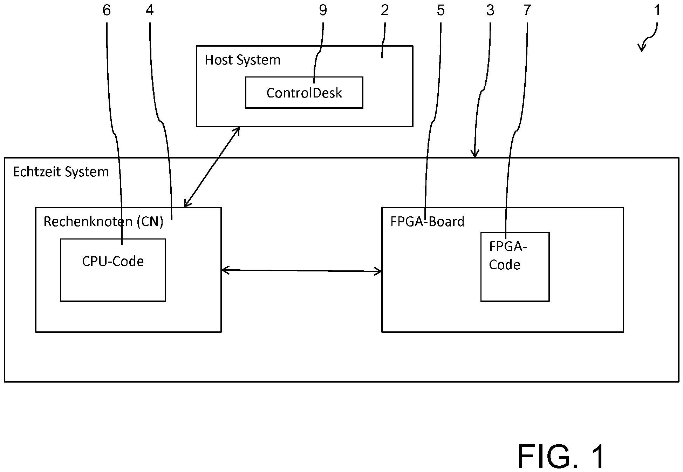

Die Figur 1 zeigt einen erfindungsgemäßen Aufbau eines Datenverarbeitungssystems 1 mit einem Steuerungsrechner 2, hier auch als Host-System gekennzeichnet, und einem Echtzeitsystem 3. Das Echtzeitsystem 3 ist mit dem Steuerungsrechner 2 über eine nicht explizit dargestellte Netzwerkverbindung verbunden.

Das Echtzeitsystem 3 umfasst einem Rechenknoten 4 mit einer nicht dargestellten CPU sowie ein FPGA-Board 5, das in diesem Ausführungsbeispiel ein Xilinx FPGA ist. Das Echtzeitsystem 3 ist hier eine beliebige Datenverarbeitungseinrichtung, auf der als CPU-Code 6 eine CPU-Applikation ausgeführt wird. Auf dem FPGA-Board 5 wird ein FPGA-Code 7 ausgeführt. Das FPGA-Board 5 ist mit einer Mehrzahl I/O-Ports 8 ausgeführt.

Auf dem Steuerungsrechner 2 wird eine Steuerungssoftware 9 ausgeführt, die in diesem Ausführungsbeispiel eine dSPACE ControlDesk Software ist. Das ControlDesk 9 kommuniziert mit dem Echtzeitsystem 3 über den Rechenknoten 4, wie in Fig. 1 gezeigt ist.

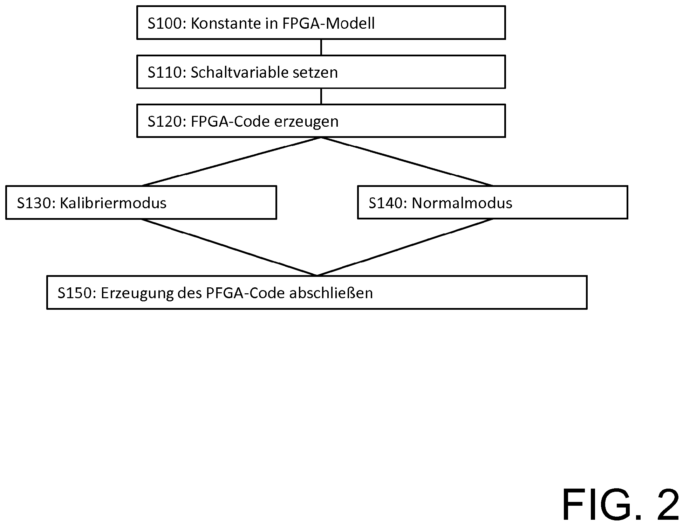

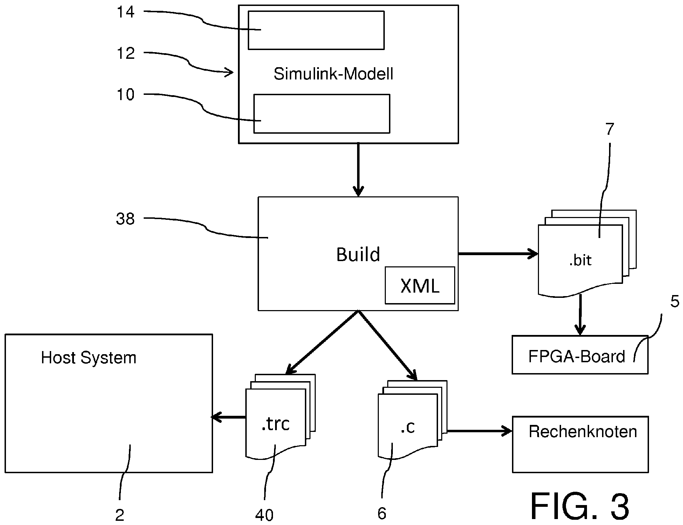

Fig. 2 zeigt ein Verfahren zum Erstellen des FPGA-Codes basierend auf einem FPGA-Modell 10 mit wenigstens einem Signalwert, der als Konstante modelliert wird, gemäß einer ersten, bevorzugten Ausführungsform. Das FPGA-Modell 10 ist Teil eines Simulink-Modells 12, welches zusätzlich ein CPU-Modell 14 umfasst, wie in Fig. 3 dargestellt. Das FPGA-Modell 10 und das CPU-Modell 14 bilden gemeinsam das gewünschte Verhalten des Echtzeitsystems 3 ab, wobei hier im Detail das FPGA-Modell 10 und dessen Implementierung betrachtet wird.

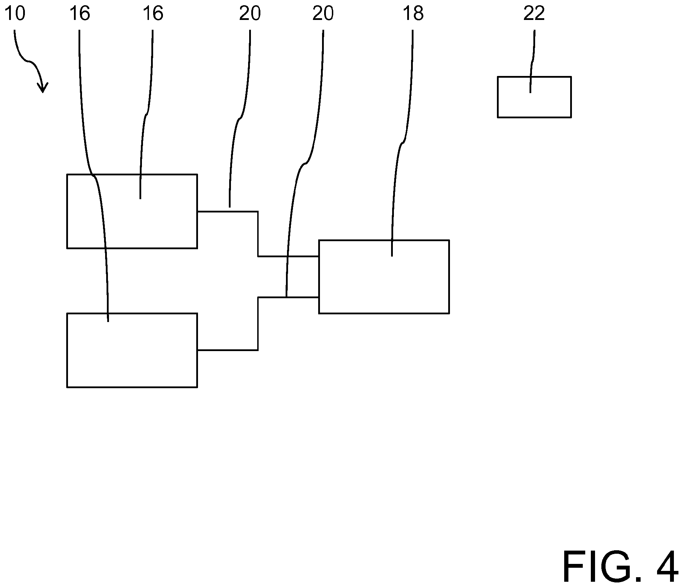

Das Verfahren beginnt mit Schritt S100. In Schritt S100 wird eine Konstante 16 mit einem vorgegebenen Signalwert in das FPGA-Modell 10 eingefügt. Das FPGA-Modell 10 ist schematisch vereinfacht in Fig. 4 dargestellt und umfasst hier beispielhaft eine weitere Konstante 16 und weitere Komponenten, die hier gemeinsam als Nutzerlogik 18 dargestellt sind. Die Konstanten 16 und die Nutzerlogik 18 sind über Signalpfade 20 wie dargestellt miteinander verbunden. Zusätzlich umfasst das FPGA-Modell 10 eine Schaltvariable 22, die global für das FPGA-Modell 10 gesetzt wird und für beide Konstanten 16 gilt. Die Schaltvariable 22 kann zwischen einem Normalmodus und einem Kalibriermodus umgeschaltet werden.

In Schritt S110 wird die Schaltvariable 22 global für das FPGA-Modell 10 gesetzt. Voreingestellt ist der Kalibriermodus.

In Schritt S120 wird der FPGA-Code 7 für das FPGA-Modell 10 erzeugt. Dabei werden abhängig von dem gesetzten Wert der Schaltvariable 22 die Konstanten 16 unterschiedlich in dem FPGA-Code 7 implementiert.

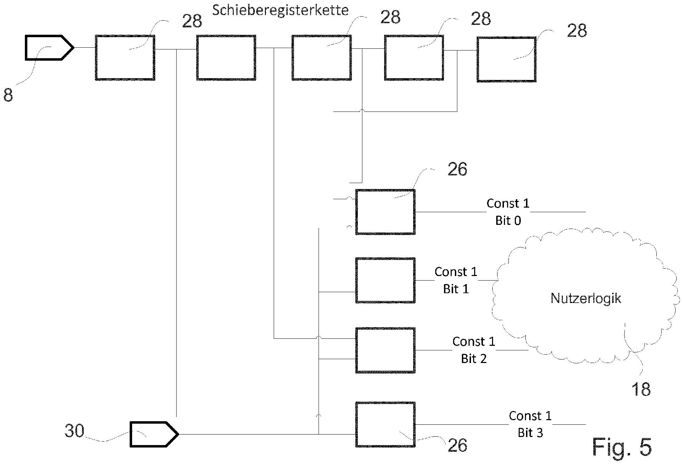

In Schritt S130 werden bei gesetzter Schaltvariable 22 für den Kalibriermodus die Konstanten 16 als veränderbare Signalwerte 24 in dem FPGA-Code 7 implementiert. Dazu werden die Konstanten 16 mit Registern 26 implementiert, wie beispielhaft für eine Konstante 16 in Fig. 5 dargestellt ist. Jedes Register 26 entspricht dabei einem Bit des veränderbaren Signalwertes 24.

Zusätzlich sind hier weitere FPGA-Komponenten 28, 30 in der Form von Schieberegistern 28 und einem Enable-Signal 30 sowie Verbindungssignalpfade 32 zum Setzen des veränderbaren Signalwerts 24 implementiert und mit dem I/O-Port 8 verbunden. Signalwerte können somit von außen über den I/O-Port 8 sequentiell in die Schieberegister 28 geladen und von dort über das Enable-Signal 30 in die Register 26 übertragen werden. Die Übertragung des Signalwerts erfolgt somit bitweise.

Die Implementierung des veränderbaren Signalwertes 24 mit Registern 26 ermöglicht außerdem ein Auslesen des veränderbaren Signalwertes 24 über hier nicht dargestellte Strukturen.

In einer alternativen Ausführungsform umfasst die Implementierung der Konstanten 16 als veränderbarer Signalwert 24 eine Mehrzahl I/O-Ports 8, die unmittelbar mit den Registern 26 verbunden sind. Über das Enable-Signal 30 wird nach dem Anlegen eines Signalwertes über die I/O-Ports 8 der Signalwert von den I/O-Ports 8 in die Register 26 als veränderbarer Signalwert 24 übernommen.

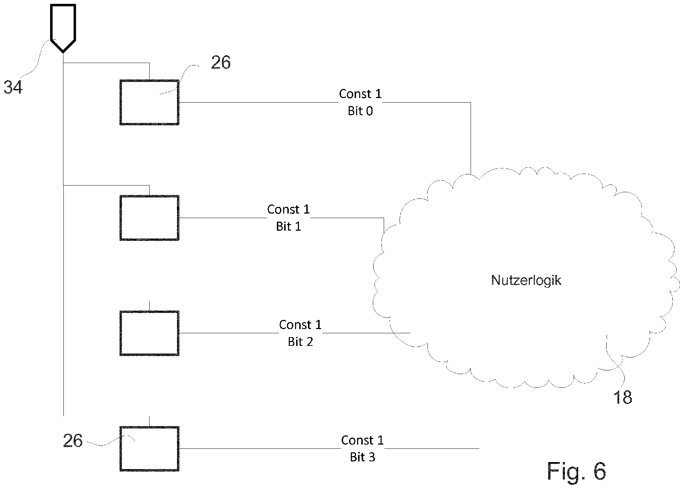

In einer weiteren alternativen Ausführungsform, die in Fig.6 gezeigt ist, werden die Register 26, welche den Wert der Konstanten repräsentieren, über partielle Rekonfiguration beschrieben. Über partielle Rekonfiguration werden neue Werte für die Register 26 in die Konfigurationsebene des FPGAs geschrieben und über das anlegen eines Reset-Signals 34 in von der Konfigurationsebene in die funktionale Ebene des FPGAs, d.h. als aktuelle Werte der Register 26 übernommen. Verbindungen zu I/O-Ports 8 können so eingespart werden.

Das Verfahren springt im Anschluss zu Schritt S150.

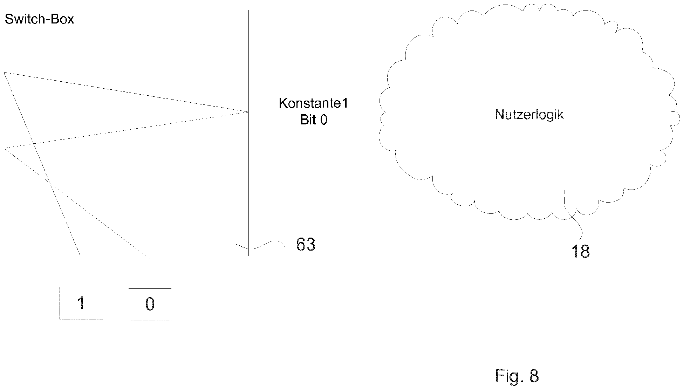

In Schritt S140 werden bei gesetzter Schaltvariable 22 für den Normalmodus die Konstanten 16 als feste Werte in dem FPGA-Code 7 implementiert. Eine beispielhafte Implementierung eines festen Wertes ist in Fig. 8 gezeigt. Der Wert wird hier durch eine direkte Verdrahtung auf 0 oder 1 bzw. die entsprechenden Spannungen festgelegt. Das Verfahren springt im Anschluss zu Schritt S150.

In Schritt S150 wird die Erzeugung des FPGA-Codes 7 abgeschlossen. Details sind in Fig. 3 dargestellt. Aus dem Simulink Modell 12 wird ausführbahrer Code durch einen Build 38 erzeugt. Dies umfasst das Erzeugen des FPGA-Codes 7 als FPGA Hardware-Konfiguration, das Erzeugen des CPU-Codes 6 für den Teil des Simulink Modells 12, der auf dem Rechenknoten 4 ausgeführt wird, und das Erzeugen von Softwarekomponenten 40 für den Steuerungsrechner 2.

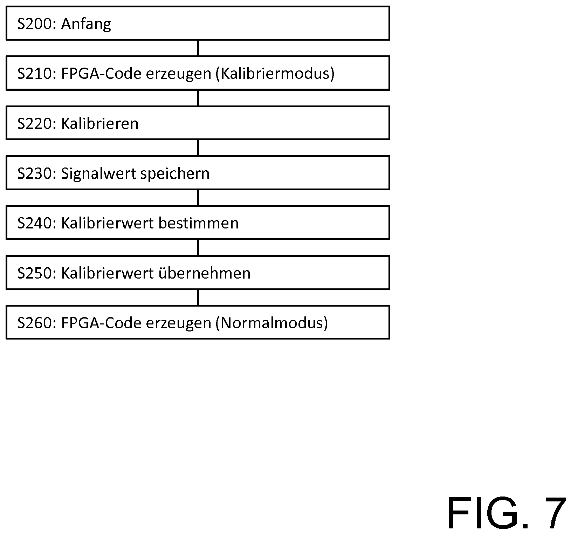

Fig. 7 zeigt ein Verfahren zum Kalibrieren eines FPGA-Modells 10. Das Verfahren beginnt mit Schritt S200.

In Schritt S210 wird das vorgenannte und unter Bezug auf Fig. 2 beschriebene Verfahren zum Erstellen eines FPGA-Codes 7 basierend auf einem FPGA-Modell 10 mit wenigstens einem Signalwert, der als Konstante 16 modelliert wird, durchgeführt. In Schritt S210 ist die Schaltvariable für den Kalibriermodus gesetzt.

In Schritt S220 wird das Kalibrieren des FPGA-Codes 7 durchgeführt. Entsprechend werden wie oben beschrieben über den I/O-Port 8 eine Mehrzahl Signalwerte für den veränderlichen Signalwert 24 an das FPGA-Board 5 übertragen und für den veränderlichen Signalwert 24 übernommen.

In Schritt S230 werden Signalwerte aus dem FPGA-Code 7 für die beiden veränderbaren Signalwerte 24 in das FPGA-Modell 10 gespeichert für die anschließende Verwendung. Schritt S230 kann wiederholt durchgeführt werden für geeignete Kalibrierwerte.

In Schritt S240 werden Signalwerte als Kalibrierwerte für die Konstanten 16 bestimmt. Die umfasst das automatische Übernehmen eines aktuellen Signalwerts aus dem FPGA-Code 7 in das FPGA-Modell 10 am Ende der Kalibrierung

In Schritt S250 werden die Kalibrierwerte für die Konstanten 16 in dem FPGA-Modell 10 übernommen. Das FPGA-Modell 10 als solches bleibt dabei unverändert.

In Schritt S260 wird erneut das vorgenannte und unter Bezug auf Fig. 2 beschriebene Verfahren zum Erstellen des FPGA-Codes 7 durchgeführt. In diesem Fall existiert jedoch bereits das FPGA-Modell 10 mit den Konstanten 16, wie es in Schritt 210 erzeugt wurde, so dass dieser Teil des Verfahren nicht erneut durchgeführt wird. In Schritt S260 ist die Schaltvariable 22 für den Normalmodus gesetzt. Somit kann der FPGA-Code 7 mit den gewünschten Kalibrierwerten erzeugt werden.

Das Verfahren ist als Computerprogrammprodukt mit Computer-implementierten Anweisungen implementiert, das nach dem Laden und Ausführen in dem Echtzeitsystem 3 die Schritte des obigen Verfahrens ausführt.

Ein digitales Speichermedium stellt elektronisch auslesbare Steuersignale bereit, die so mit dem Echtzeitsystem 3 zusammenwirken, dass das obige Verfahren auf dem Echtzeitsystem 3 ausgeführt wird.

### Bezugszeichenliste

- Datenverarbeitungssystem: 1
- Steuerungsrechner: 2
- Echtzeitsystem: 3
- Rechenknoten: 4
- FPGA-Board: 5
- CPU-Code: 6
- FPGA-Code: 7
- I/O-Port: 8
- Steuerungssoftware, ControlDesk: 9
- FPGA-Modell: 10
- Simulink-Modell: 12
- CPU-Modell: 14
- Konstante: 16
- Nutzerlogik: 18
- Signalpfad: 20
- Schaltvariable: 22
- veränderbarer Signalwert: 24
- Register: 26
- Schieberegister: 28
- Enable-Signal: 30
- Verbindungssignalpfad: 32
- Reset-Signal: 34
- Build: 38
- Softwarekomponente: 40

## Patentansprüche

1. Verfahren zum Erstellen eines FPGA-Codes (7) basierend auf einem FPGA-Modell (10) mit wenigstens einem Signalwert, der als Konstante (16) modelliert wird, umfassend die Schritte
Einfügen einer Konstanten (16) mit einem vorgegebenen Signalwert in dem FPGA-Modell (10),
Setzen einer Schaltvariablen (22) in dem FPGA-Modell (10) zum Umschalten zwischen einem Normalmodus und einem Kalibriermodus für den FPGA-Code (7),
Erzeugen des FPGA-Codes (7) für das FPGA-Modell (10) umfassend das Implementieren der Konstanten (16) in dem FPGA-Code (7), wobei
das Implementieren der Konstanten (16) bei gesetzter Schaltvariable (22) für den Normalmodus das Implementieren der Konstanten (16) als fester Wert in dem FPGA-Code (7) umfasst, und
das Implementieren der Konstanten (16) bei gesetzter Schaltvariable (22) für den Kalibriermodus das Implementieren der Konstanten (16) als veränderbarer Signalwert (24) in dem FPGA-Code (7) umfasst, **dadurch gekennzeichnet, dass**
der Schritt des Implementierens der Konstanten (16) als veränderbarer Signalwert (24) das Implementieren der Konstanten (16) mit Registern (26) umfasst,
wobei über partielle Rekonfiguration neue Werte für die Register (26) in die Konfigurationsebene des FPGAs geschrieben und über das Anlegen eines Reset-Signals (34) von der Konfigurationsebene in die funktionale Ebene des FPGAs übernommen werden.

2. Verfahren nach Anspruch 1, **dadurch gekennzeichnet, dass**
der Schritt des Einfügen einer Schaltvariablen (22) in dem FPGA-Modell (10) zum Umschalten zwischen einem Normalmodus und einem Kalibriermodus das Zuordnen der Schaltvariablen (22) zu wenigstens einer Konstanten (16) umfasst.

3. Verfahren nach einem der vorhergehenden Ansprüche, **dadurch gekennzeichnet, dass**
das FPGA-Modell für Konstanten zwischen mindestens einem Festwertblock und mindestens einem Kalibrierblock unterscheidet, wobei der Wert des mindestens einen Festwertblock unabhängig von der Schaltvariablen als fester Wert im FPGA-Code implementiert wird und der Wert des mindestens einen Kalibrier-Block in Abhängigkeit der Schaltvariablen im Normalmodus als fester Wert und im Kalibriermodus als veränderbarer Signalwert implementiert wird.

4. Datenverarbeitungseinrichtung mit einer Prozessoreinheit, wobei die Datenverarbeitungseinrichtung (3) zur Durchführung des Verfahrens nach einem der Ansprüche 1 bis 2 ausgeführt ist.

5. Computerprogrammprodukt mit Computer-implementierten Anweisungen, das nach dem Laden und Ausführen in einer geeigneten Datenverarbeitungseinrichtung (3) die Schritte des Verfahrens nach einem der Ansprüche 1 bis 2 ausführt.

6. Digitales Speichermedium mit elektronisch auslesbaren Steuersignalen, die so mit einer programmierbaren Datenverarbeitungseinrichtung (3) zusammenwirken können, dass das Verfahren nach einem der Ansprüche 1 bis 2 auf der Datenverarbeitungseinrichtung (3) ausgeführt wird.

## Claims

1. A method for producing an FPGA code (7) based on an FPGA model (10) having at least one signal value modeled as a constant (16), comprising the steps
inserting a constant (16) having a defined signal value in the FPGA model (10), setting a switching variable (22) in the FPGA model (10) for switching between a normal mode and a calibration mode for the FPGA code (7),
generating the FPGA code (7) for the FPGA model (10) comprising the implementing of the constants (16) in the FPGA code (7),
the implementing of the constants (16) when the switching variable (22) is set for the normal mode comprising the implementing of the constants (16) as a fixed value in the FPGA code (7), and
the implementing of the constants (16) when the switching variable (22) is set for the calibration mode comprising the implementing of the constants (16) as a modifiable signal value (24) in the FPGA code (7), **characterized in that**
the step of implementing the constants (16) as modifiable signal value (24) comprises implementing the constants (16) by means of registers (26),
wherein new values for the registers (26) are written in the configuration level of the FPGS by means of partial reconfiguration and are transferred from the configuration level into the functional level of the FPGA by means of applying a reset signal (34).

2. The method according to claim 1, **characterized in that**
the step of inserting a switching variable (22) in the FPGA model (10) for switching between a normal mode and a calibration mode comprises assigning the switching variables (22) to at least one constant (16).

3. The method according to any one of the preceding claims, **characterized in that**
the FPGA model differentiates between at least one fixed value block and at least one calibration block for constants, wherein the value of the at least one fixed value block is implemented independently of the switching variables as a fixed value in the FPGA code and the value of the at least one calibration block is implemented dependently of the switching variables as a fixed value in normal mode and as a modifiable signal value in calibration mode.

4. A data-processing device having a processor unit, wherein the data-processing device (3) is implemented for performing the method according to any one of the claims 1 through 2.

5. A computer program product having computer-implemented instructions and executing the steps of the method according to any one of the claims 1 through 2 after loading and executing in a suitable data-processing device (3).

6. A digital storage medium having electronically readable control signals able to interact with a programmable data-processing device (3) such that the method according to any one of the claims 1 through 2 is executed on the data-processing device (3).

## Revendications

1. Procédé pour créer un code FPGA (7) sur la base d'un modèle FPGA (10) avec au moins une valeur de signal, lequel est modelé en tant que constante (16), comprenant les étapes suivantes :
insérer une constante (16) avec une valeur de signal prédéterminée dans le modèle FPGA (10),
définir une variable de commutation (22) dans le modèle FPGA (10) pour la commutation entre un mode normal et un mode d'étalonnage pour le code FPGA (7),
générer le code FPGA (7) pour le modèle FPGA (10), comprenant l'implémentation de la constante (16) dans le code FPGA (7), sachant que
l'implémentation de la constante (16) à l'état activé de la variable de commutation (22) pour le mode normal comprend l'implémentation de la constante (16) en tant que valeur fixe dans le code FPGA (7), et
l'implémentation de la constante (16) à l'état activé de la variable de commutation (22) pour le mode d'étalonnage comprend l'implémentation de la constante (16) en tant que valeur de signal (24) variable dans le code FPGA (7), **caractérisé en ce que**
l'étape d'implémentation de la constante (16) en tant que valeur de signal (24) variable comprend l'implémentation de la constante (16) avec des registres (26),
sachant que, par une reconfiguration partielle, de nouvelles valeurs pour les registres (26) sont écrites dans le niveau de configuration du FPGA et, par définition d'un signal de remise à zéro (34), reprises du niveau de configuration au niveau fonctionnel du FPGA.

2. Procédé selon la revendication 1, **caractérisé en ce que**
l'étape d'insertion d'une variable de commutation (22) dans le modèle FPGA (10) pour la commutation entre un mode normal et un mode d'étalonnage comprend l'allocation de la variable de commutation (22) à au moins une constante (16).

3. Procédé selon l'une des revendications précédentes, **caractérisé en ce que**
le modèle FPGA, pour les constantes, différencie entre au moins un bloc de valeurs fixes et au moins un bloc d'étalonnage, sachant que la valeur de l'au moins un bloc de valeurs fixes est implémentée en tant que valeur fixe dans le code FPGA indépendamment de la valeur de commutation et la valeur de l'au moins un bloc d'étalonnage est implémentée en fonction de la variable de commutation, en tant que valeur fixe en mode normal et en tant que valeur de signal variable en mode d'étalonnage.

4. Dispositif de traitement de données avec une unité de processeur, dans lequel le dispositif (3) de traitement des données est réalisé pour exécuter le procédé selon l'une des revendications 1 à 2.

5. Produit de programme informatique avec des instructions implémentées sur ordinateur, qui, après le chargement et le lancement dans un dispositif (3) de traitement de données approprié, exécute les étapes du procédé selon l'une des revendications 1 à 2.

6. Support de stockage numérique avec des signaux de commande lisibles électroniquement, qui peuvent coopérer avec un dispositif (3) de traitement de données programmable de sorte que le procédé selon l'une des revendications 1 à 2 soit exécuté sur le dispositif (3) de traitement de données.
